# EUROPEAN PATENT APPLICATION

(11) **EP 2 568 367 A2**
(43) Date of publication of application: **13.03.2013**
(21) Application number: 12183267.9
(22) Date of filing: 06.09.2012
(51) Int. Cl.: G06F 3/044

(54) **Touch screen, transparent circuit board for touch screen and method for fabricating touch screen**

(30) Priority: 06.09.2011 KR 20110089984
(71) Applicant: Sehf-Korea Co., Ltd., Gumi-si, Gyeongsangbuk-do (KR)
(72) Inventor: Cho, Yong-Gu, Gyeongsangbuk-do (KR); Yang, Hae-Jung, Gyeongsangbuk-do (KR)
(74) Representative: Grünecker, Kinkeldey, Stockmair & Schwanhäusser

(57) **Abstract**

Provided is a method for fabricating a transparent circuit board for a touch screen. The transparent circuit board includes a transparent substrate that has a conductive bridge layer deposited thereon. A liquid insulating layer is deposited on the transparent substrate and the bridge layer, and a sensor layer having first and second conductive patterns is deposited on the transparent substrate and the insulating layer.

## Description

### Field of the Invention

The following description relates generally to a touch screen, and more particularly, to a transparent circuit board for a touch screen which forms the front of the touch screen and has a sensor layer.

### Background to the Invention

In general, a touch screen is made by integrating an input/output means into a display. A typical touch screen includes a display unit such as Liquid Crystal Display (LCD), and a touch panel disposed on the display unit. A touch screen may receive or detect a user input when the user touches the screen touch by identifying a specific location where a user's fingertip or other objects touch the associated character or region shown on the screen without the use of a mechanical keypad.

The touch screen does not need a mechanical keypad and is easy to manipulate. Accordingly, the touch screen is widely used as an information display device in areas where a lot of people tend to gather, i.e., public places such as subway stations, department stores, and banks. Currently, the touch screen is not only applied to sale terminals in stores, but is also widely used in portable terminals such as mobile phones, Digital Multimedia Broadcasting (DMB) receivers, car navigation terminals, and the like. For example, touch screens (or touch panels) may be classified into a resistive overlay touch screen, a capacitive touch panel, a surface acoustic wave touch screen, an infrared beam touch screen, and the like.

Conventionally, when a capacitive touch panel is fabricated, an insulating layer constituting a part of a sensor layer is formed by a photolithography process. In the photolithography process, an insulating layer having a predetermined pattern is formed by depositing a photoresist. Next, curing (i.e., performing a lithography step on) is performed on the photoresist by partially (or selectively) irradiating ultraviolet rays to the photoresist using a mask that is spaced apart from the photoresist by a predetermined gap. Finally, an uncured portion of the photoresist is removed using a developer.

The photolithography process is introduced when a sensor layer is formed. Accordingly, many process steps are required to form the sensor layer and the process time is lengthy, causing an increase in waste of materials and a reduction in yield. Furthermore, due to the step coverage at the edge of the insulating layer, the conductive patterns may be partially open.

In an effort to solve the problems caused by the step coverage at the edge of the insulating layer, a method of reducing the inclination of the edge of the insulating layer by adjusting the gap between a photoresist and a mask and the intensity of ultraviolet light in the lithography step has been considered. However, due to the difficulty of adjusting the inclination, stability of the sensor layer may decrease and the photolithography process time may be delayed, causing a further decrease in yield and a further increase in waste of materials.

### Summary of the Invention

In an aspect, there is provided a method for fabricating a transparent circuit board for a touch screen, the method including forming a transparent substrate on which a conductive bridge layer is deposited, depositing a liquid insulating layer on the transparent substrate and on the bridge layer, and depositing a sensor layer on the transparent substrate and the insulating layer, the sensor layer comprising first and second conductive patterns that cross each other.

The liquid insulating layer may be deposited by an inkjet printing process.

The forming of the transparent substrate may comprise depositing a conductive layer on a surface of the transparent substrate, and plasma-etching the surface of the transparent substrate on which the conductive layer is deposited to form the conductive bridge layer.

The method may further comprise washing the plasma-etched surface of the transparent substrate with an alkaline solution.

The alkaline solution may comprise at least one of tetramethylammonium hydroxide (TMAH) and NaHCO₃.

The method may further comprise curing the liquid insulating layer by heating the liquid insulating layer.

The method may further comprise depositing a light blocking layer on edges of the transparent substrate, and depositing an electrode layer on the light blocking layer, wherein the electrode layer is electrically connected to the sensor layer.

The method may further comprise depositing an insulating protective layer onto the sensor layer such that the insulating protective layer is interposed between the first and second conductive patterns.

In an aspect, there is provided a transparent circuit board for a touch screen, the transparent circuit board including a transparent substrate comprising a conductive bridge layer which has undergone plasma etching, an insulating layer deposited on the transparent substrate and on the conductive bridge layer, and a sensor layer comprising first and second conductive patterns that cross each deposited on the transparent substrate and the insulating layer.

The insulating layer may be deposited by an inkjet printing process.

An angle of inclination of an edge of the insulating layer may range from 30° to 60°.

The transparent circuit board may further comprise a light blocking layer deposited on edges of the transparent substrate, and an electrode layer deposited on the insulating light blocking layer and electrically connected to the sensor layer.

In an aspect, there is provided a touch screen including a transparent circuit board configured to sense a touch, the transparent circuit board comprising a transparent substrate including a conductive bridge layer, an insulating layer deposited on the transparent substrate and on the conductive bridge layer, and a sensor layer comprising first and second conductive patterns that cross each deposited on the transparent substrate and the insulating layer, and a display unit configured to display an image.

The insulating layer may be deposited by an inkjet printing process.

An angle of inclination of an edge of the insulating layer may range from 30° to 60°.

Other features and aspects may be apparent from the following detailed description, the drawings, and the claims.

### Brief Description of the Drawings

FIG. 1 is a diagram illustrating an example of a method for fabricating a transparent circuit board for a touch screen.
FIGS. 2 to 16 are diagrams illustrating various examples of fabricating a transparent circuit board for touch a screen.
FIG. 17 is a diagram illustrating an example of a touch screen.

Throughout the drawings and the detailed description, unless otherwise described, the same drawing reference numerals will be understood to refer to the same elements, features, and structures. The relative size and depiction of these elements may be exaggerated for clarity, illustration, and convenience.

### Description of Embodiments of the Invention

The following detailed description is provided to assist the reader in gaining a comprehensive understanding of the methods, apparatuses, and/or systems described herein. Accordingly, various changes, modifications, and equivalents of the methods, apparatuses, and/or systems described herein will be suggested to those of ordinary skill in the art. Also, descriptions of well-known functions and constructions may be omitted for increased clarity and conciseness.

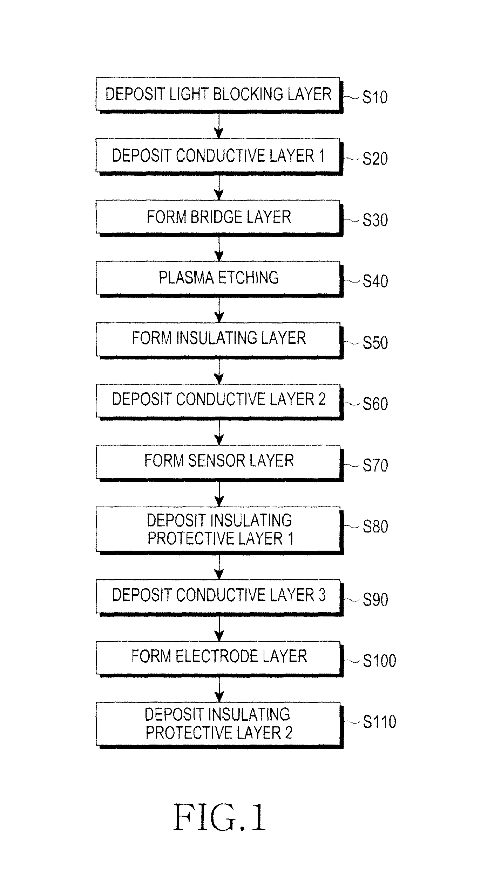

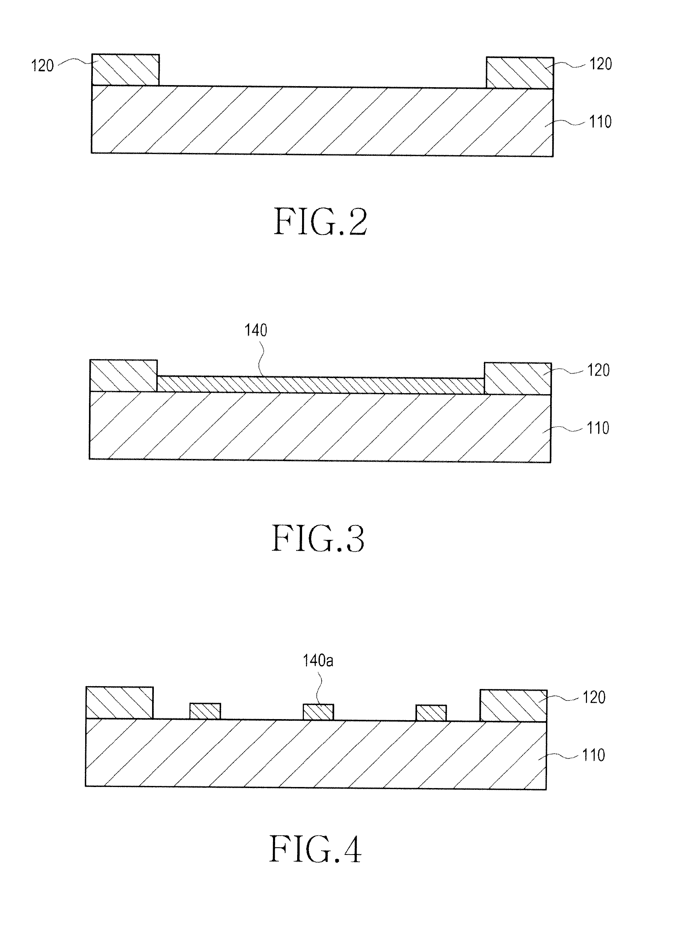

FIG. 1 illustrates an example of a method for fabricating a transparent circuit board for a touch screen, and FIGS. 2 to 16 illustrate examples of various operations for fabricating a transparent circuit board for a touch screen. The touch screen may be included in a terminal, for example, a mobile phone, a tablet, a computer, a camera, a display, a television, an appliance, and the like.

Referring to FIG. 1, the method for fabricating a transparent circuit board for a touch screen includes depositing a light blocking layer (S10), depositing a first conductive layer (S20), forming a bridge layer (S30), performing plasma etching (S40), forming an insulating layer (S50), depositing a second conductive layer (S60), forming a sensor layer (S70), depositing a first insulating protective layer (S80), depositing a third conductive layer (S90), forming an electrode layer (S100), and depositing a second insulating protective layer (S 110).

Referring to FIGS. 1 and 2, in step S10 of depositing a light blocking layer, a light blocking layer 120 is deposited on a surface periphery (or edge) of a transparent substrate 110. For example, the light blocking layer 120 may be deposited on an upper surface periphery of the transparent substrate 110 to have a form of a rectangular strip. A lower surface of the transparent substrate 110 forms at least part of the front of the touch screen, which is exposed to the outside. The transparent substrate 110 may be formed of an insulating material which is transparent to visible light. Examples of the insulating material include glass, polyethylene terephthalate (PET), polycarbonate (PC), and the like. The lower surface of the transparent substrate 110 is exposed to the outside. Accordingly, the light blocking layer 120 blocking visible light is deposited on the upper surface periphery of the transparent substrate 110 to prevent the outer periphery (i.e., a non-display area) around a central portion (i.e., a display area) of the transparent substrate 110 from being visible on the outside. The light blocking layer 120 may be formed by a process such as black ink printing. For example, a material used for the light blocking layer 120 may include screen printing ink containing resin such as polyethylene (PE), acryl, polyurethane (PU), and the like.

Referring to FIGS. 1 and 3, in step S20 of depositing a first conductive layer, a first conductive layer 140 is deposited on an exposed upper surface of the transparent substrate 110. The first conductive layer 140 is formed of a conductive material which is transparent to visible light. Examples of the conductive material of the first conductive layer include Indium Tin Oxide (ITO), poly(3,4-ethylenedioxythiophene (PEDOT), and the like. The first conductive layer 140 may be formed by a vacuum deposition process such as E-beam, sputtering, and the like.

Referring to FIGS. 1 and 4, in step S30 of forming a bridge layer, a bridge layer 140a having a predetermined pattern is formed by partially (or selectively) etching the first conductive layer 140. For example, the bridge layer 140a may include conductive strips which are located at intersections of first and second conductive patterns constituting a sensor layer.

The bridge layer 140a may be patterned by the photolithography process. In the photolithography process, for example, a photoresist mask that has a plurality of slits may be formed by depositing a photoresist over the entire upper surface of the first conductive layer 140, curing the photoresist by partially (or selectively) irradiating ultraviolet rays to the photoresist, and removing an uncured portion of the photoresist using a developer. The photoresist may have a uniform thickness. The bridge layer 140a may be formed by etching and removing the portions of the first conductive layer 140, which are exposed through the slits of the photoresist mask.

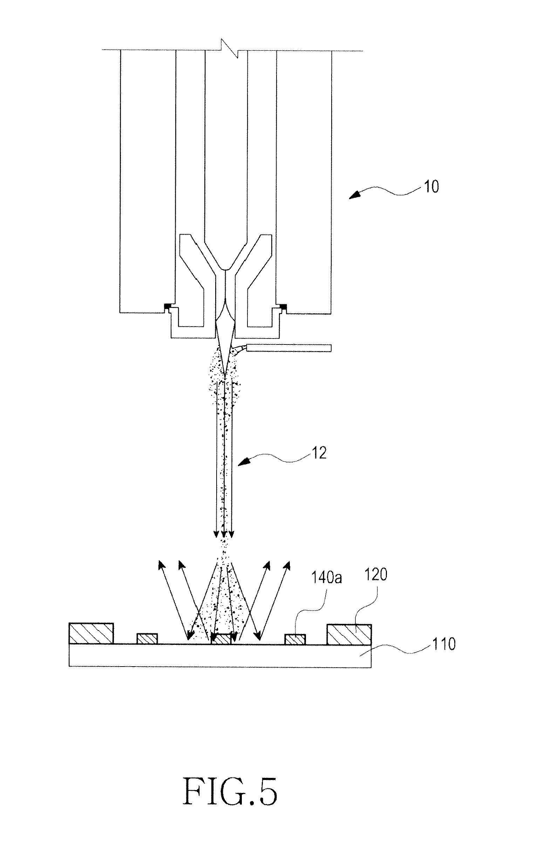

Referring to FIGS. 1 and 5, in step S40 of performing plasma etching, the surface of the transparent substrate 110 is plasma-etched. The plasma etching may be performed by etching plasma ions 12 generated and accelerated by a common plasma etcher 10 onto the surface (i.e., upper surface) of the transparent substrate 110. The plasma etching may improve the quality of the surface of the transparent substrate 110. Thereafter, if a liquid insulating layer is printed on the surface of the plasma-etched transparent substrate 110, the contact angle (i.e., a tangential angle of the edge end of the liquid insulating layer) of the liquid insulating layer may be reduced. In order to further reduce the contact angle of the liquid crystal layer, the surface of the plasma-etched transparent substrate 110 may be washed with a weak alkaline solution such as tetramethylammonium hydroxide (TMAH) and NaHCO₃.

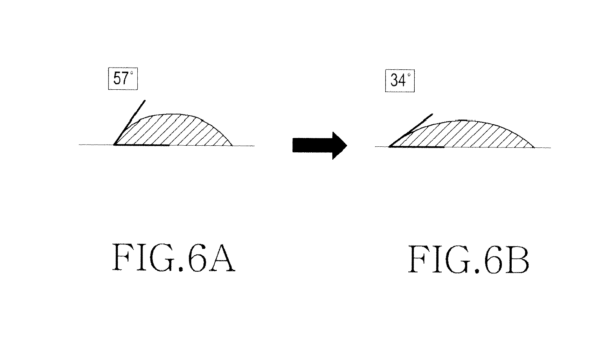

FIGS. 6A and 6B illustrate an example of a change in a contact angle of an ink drop before and after the washing with a weak alkaline solution. FIG. 6A illustrates an example in which an insulting ink drop has fallen down on a plasma-etched glass substrate. In this example, the ink drop has a contact angle of about 57°. FIG. 6B illustrates an example in which an insulting ink drop has fallen down on a glass substrate which has been washed with a weak alkaline solution after undergoing plasma etching. In this example, the ink drop has a contact angle of about 34°. On a rotational symmetrical plane (i.e., a cross section passing through one point of an edge end and the central point of an ink drop) of an ink drop, the contact angle refers to an angle between a virtual segment connecting the one point of the edge and the central point, and a virtual tangent line of an outline of the ink drop, which passes through the one point of the edge on the rotational symmetrical plane. In other words, the contact angle refers to an angle formed between the glass substrate and the tangent line that passes through one point of the edge end of the ink drop on the rotational symmetrical plane.

Although step S40 of performing plasma etching is described as being performed after the step S10 of depositing a light blocking layer in this embodiment, in various examples the step S40 of performing plasma etching may be performed before the step S10 of depositing a light blocking layer.

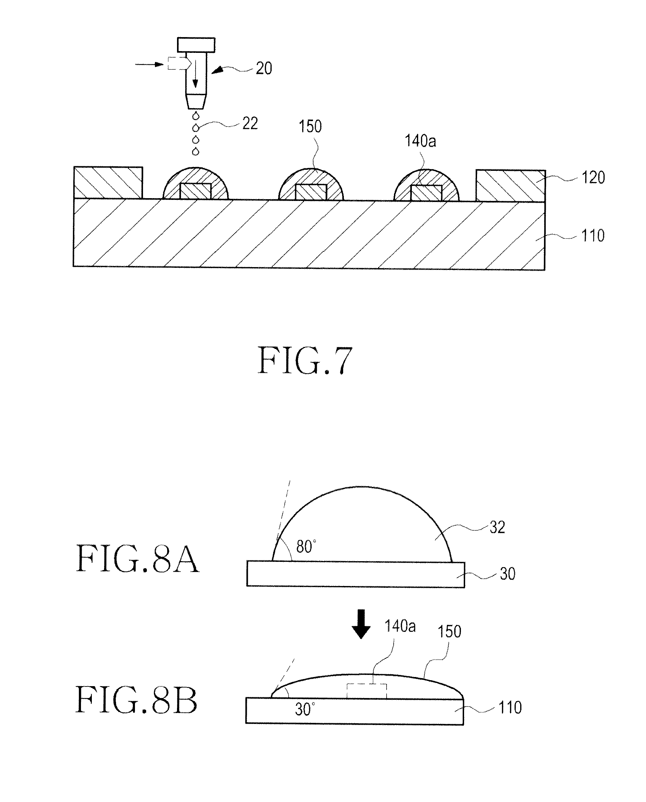

Referring to FIGS. 1 and 7, in step S50 of forming an insulating layer, a liquid insulating layer 150 may be deposited on the bridge layer 140a using an inkjet printer head 20 (or an ink dispenser). In this example, the inkjet printer head 20 is aligned with the conductive strips of the bridge layer 140a, and insulating inks 22 are deposited on the conductive strips by jetting the insulating inks 22 in a vertical direction. The insulating layer 150 includes a plurality of insulating strips to electrically isolate the first and second conductive patterns. The plurality of insulating strips may be deposited on the conductive strips on a one-to-one basis, and the corresponding conductive strips and insulating strips cross each other (e.g., in the form of cross). Thereafter, the liquid insulating layer 150 is cured, for example, by a baking process (i.e., heat-drying process) and the like.

FIGS. 8A and 8B illustrate an example of a change in contact angle of an insulating layer. FIG. 8A illustrates an example in which a liquid insulating layer 32 is deposited on a conventional transparent substrate 30. In this example, the insulating layer 32 has a contact angle of about 80°. FIG. 8B illustrates an example in which the liquid insulating layer 150 is deposited on the proposed transparent substrate 110 which has been washed with a weak alkaline solution after undergoing plasma etching. In this example, the insulating layer 150 has a contact angle of about 30°. For example, the contact angle (i.e., an inclination of an edge of the insulating layer) of the insulating layer may fall within a range of about 30° to about 60°, for example, about 30° to about 40°.

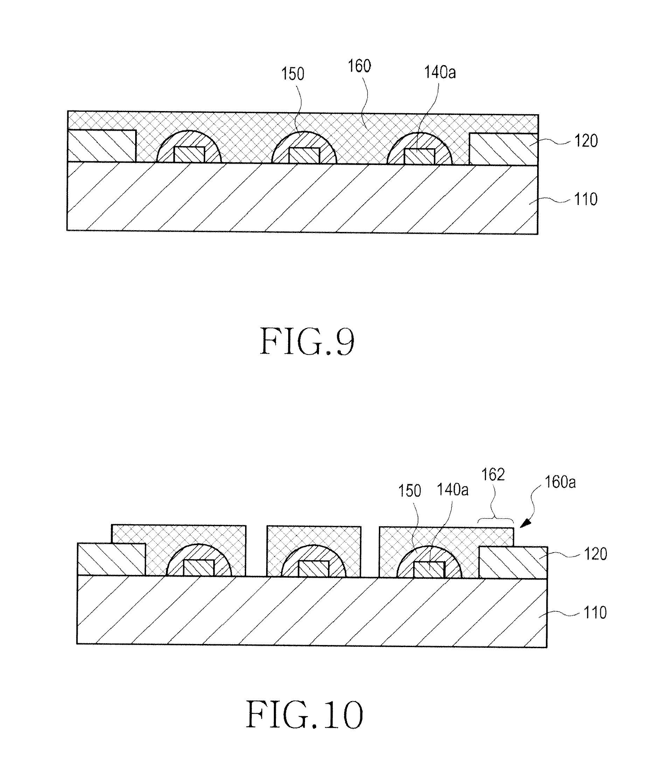

Referring to FIGS. 1 and 9, in step S60 of depositing a second conductive layer, a second conductive layer 160 is deposited on the exposed upper surface of the transparent substrate 110, the light blocking layer 120, the bridge layer 140a, and the insulating layer 150. For example, the second conductive layer 160 may be deposited over the entire upper surface of the structure shown in FIG. 7. The second conductive layer 160 may be formed of the same material as the first conductive layer 140.

Referring to FIGS. 1 and 10, in step S70 of forming a sensor layer, a sensor layer 160a having a predetermined pattern is formed by partially (or selectively) etching the second conductive layer 160. The sensor layer 160a may be formed such that its end 162 overlaps the light blocking layer 120, so the sensor layer 160a may be connected to an electrode layer on the light blocking layer 120. In this example, the ends of the light blocking layer 120 protrude outward farther than the ends 162 of the sensor layer 160a.

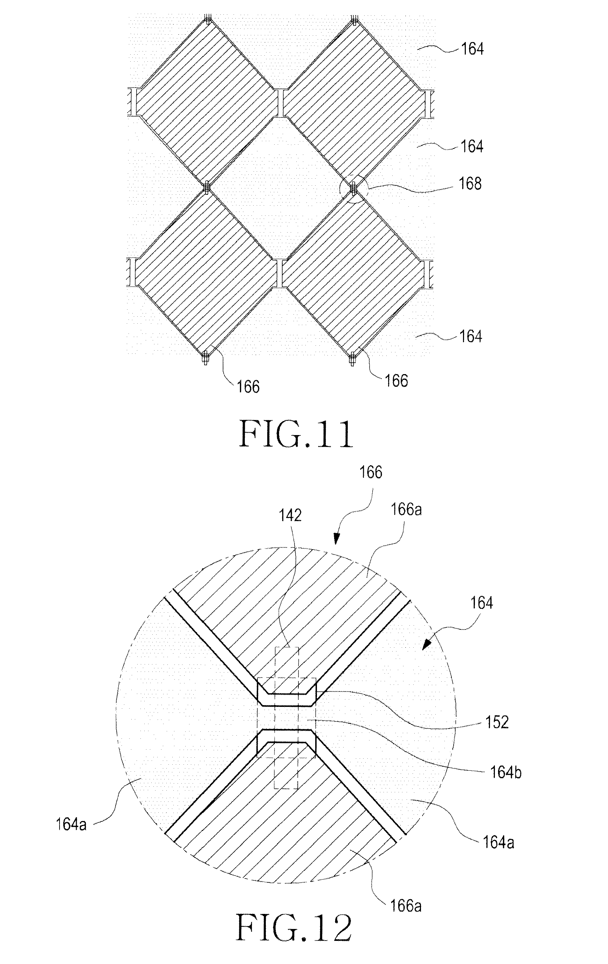

FIG. 11 illustrates an example of the sensor layer 160a, and FIG. 12 illustrates an example of an enlarged view showing one intersection 168 of the sensor layer 160a. The sensor layer 160a includes first conductive patterns 164 extending along a first direction, and second conductive patterns 166 extending along a second direction (perpendicular to the first direction).

The first and second conductive patterns 164 and 166 cross each other at a plurality of points on the transparent substrate 110. In this example, the bridge layer 140a enables the second conductive patterns 166 to be electrically connected at these intersections without being cut off. The insulating layer 150 enables the first and second conductive patterns 164 and 166 to be isolated from each other at these intersections. Each of the second conductive patterns 166 includes a plurality of second sections 166a, which are separated from each other, with the first conductive patterns 164 interposed therebetween. The plurality of second sections 166a are electrically connected by conductive strips 142 of the bridge layer 140a. Each of the first conductive patterns 164 includes a plurality of first sections 164a which are electrically connected to each other, and connection portions 164b between the plurality of first sections 164a which are deposited on insulating strips 152, respectively.

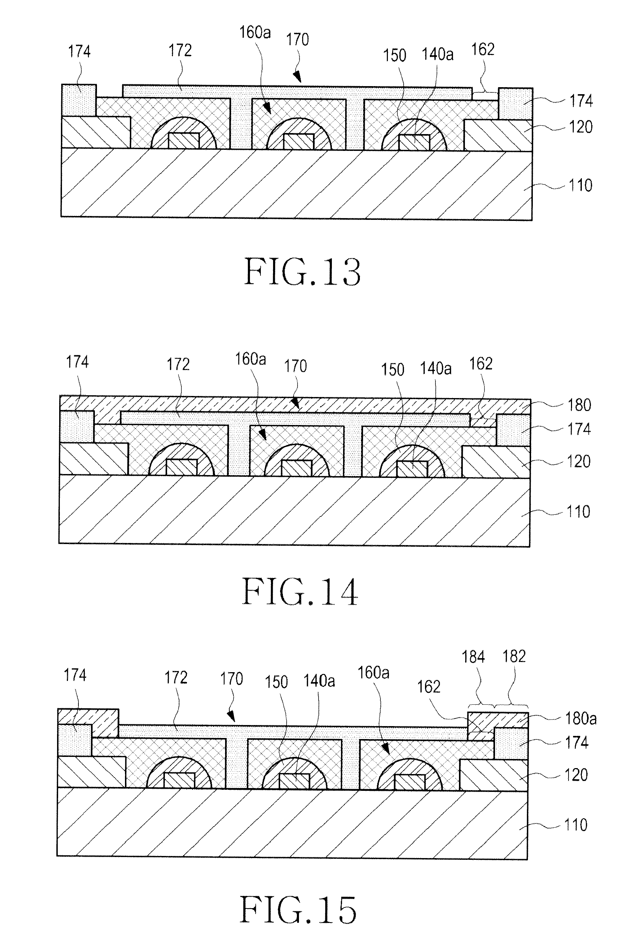

Referring to FIGS. 1 and 13, in step S80 of depositing a first insulating protective layer, a first insulating protective layer 170 is deposited on the exposed upper surface of the transparent substrate 110, the light blocking layer 120, and the sensor layer 160a. For example, the first insulating protective layer 170 may be deposited on most of the upper surface of the structure shown in FIG. 10. The first insulating protective layer 170 may not be deposited on the ends 162 of the sensor layer 160a, which are located on the light blocking layer 120. Accordingly, the ends 162 of the sensor layer 160a may be exposed to the outside. A material used for the first insulating protective layer 170 may include an insulating dielectric material such as SiO₂.

Referring to FIGS. 1 and 14, in step S90 of depositing a third conductive layer, a third conductive layer 180 is deposited on the exposed ends 162 of the sensor layer 160a and the first insulating protective layer 170. For example, the third conductive layer 180 may be deposited over the entire upper surface of the structure shown in FIG. 13.

Referring to FIGS. 1 and 15, in step S100 of forming an electrode layer, an electrode layer 180a having a predetermined pattern is formed by partially (or selectively) etching the third conductive layer 180. The electrode layer 180a may be deposited on a periphery 174 of the first insulating protective layer 170 to be located in an outer side of the sensor layer 160a. The portion of the electrode layer 180a that is deposited on a central portion 172 of the first insulating protective layer 170 may be removed from the third conductive layer 180.

For its electrical connection to the sensor layer 160a, the electrode layer 180a is formed to partially overlap the ends 162 of the sensor layer 160a. In this example, the electrode layer 180a includes connection terminals 182 for applying a current to the sensor layer 160a, and connection lines 184 connecting the connection terminals 182 to the first and second conductive patterns 164 and 166 of the sensor layer 160a. The connection terminals 182 are disposed at an outer side of the sensor layer 160a to facilitate easy access from the outside.

For example, the electrode layer 180a may be formed of a material applicable to the sensor layer 160a, or may be formed of a different material (e.g., non-transparent conductive material such as silver). The connection terminals 182 of the electrode layer 180a may be connected to, for example, a Flexible Printed Circuit Board (FPCB) (not shown) connected to a controller (not shown).

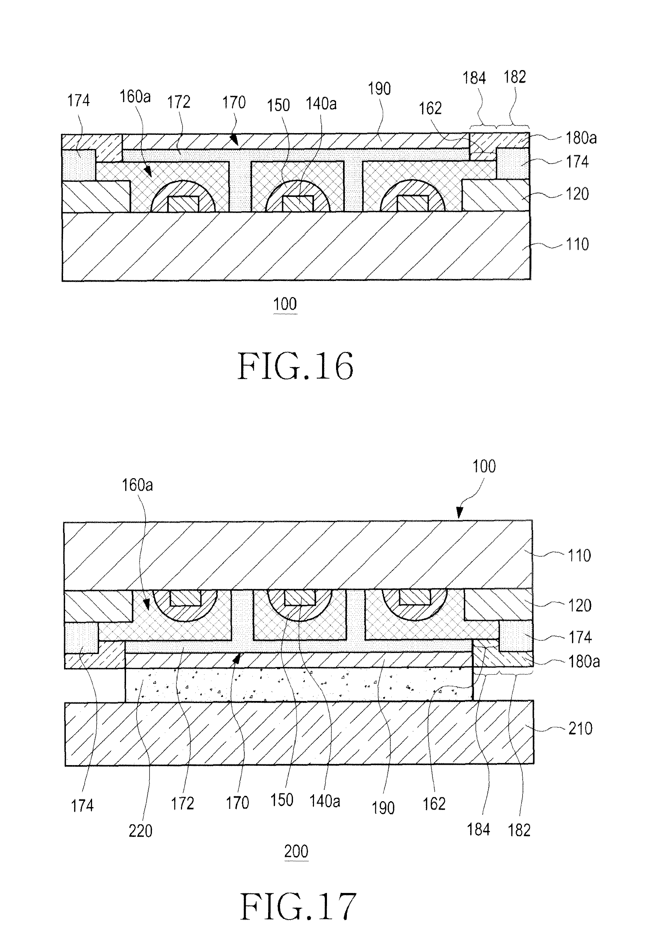

Referring to FIGS. 1 and 16, in step S110 of depositing a second insulating protective layer, a second insulating protective layer 190 is deposited on the central portion 172 of the first insulating protective layer 170. For example, a material used for the second insulating protective layer 190 may include an insulating dielectric material such as SiO₂,

An example of a touch screen, to which a transparent circuit board 100 may be applied, is further described below. The transparent circuit board 100 and a method for fabricating the same may be applied to a variety of touch screens, and it should be noted that the following description is merely an example.

FIG. 17 illustrates an example of a touch screen.

In the example of a touch screen 200 shown in FIG. 17, the transparent circuit board 100 shown in FIG. 16 is applied upside down. Duplicate description of the transparent circuit board 100 is omitted for conciseness. In this example, the upper surface of the substrate 110 receives touch input from a user.

The touch screen 200 includes a display unit 210, the transparent circuit board 100, and an adhesive member 220. The display unit 210 includes a plurality of pixels (not shown) and may display images by means of the pixels. Although a partial upper surface (e.g., central portion) of the display unit 210 is included in an effective display area of the touch screen 200, which is visible to the viewer, in another example the entire upper surface of the display unit 210 may be included in the effective display area. For example, the display unit 210 may include Liquid Crystal Display (LCD), Organic Light Emitting Diodes (OLED), and the like.

Typically, an LCD displays images under control of a controller (not shown). A typical LCD includes a liquid crystal display panel having a liquid crystal layer displaying images, and a back light unit (BLU) for providing light to the liquid crystal display panel. The liquid crystal display panel includes the liquid crystal layer, and upper and lower glass substrates disposed on and below the liquid crystal layer to control the arrangement of liquid crystal molecules. The lower glass substrate includes thin-film transistors (TFTs) and pixel electrodes, and the upper glass substrate includes a common electrode. The liquid crystal display panel further includes upper and lower polarization plates, which are disposed on and below the liquid crystal layer and linearly polarize the light being incident thereon. Polarization directions of the upper and lower polarization plates cross each other.

According to various aspects herein, the transparent circuit board 100 is attached (or adhered) to the display unit 210 using the adhesive member 220. In other words, a portion (e.g., the second insulating protective layer 190) on the bottom of the transparent circuit board 100 is attached to the entire surface of the top of the display unit 210 using the adhesive member 220. The adhesive member 220 is formed of an insulating material which is transparent to visible light. For example, a material used for the adhesive member 220 may include Optical Clear Adhesive (OCA) tape, glue (or adhesive), UV-curable resin, and the like, which are transparent to visible light. The OCA tape is a double-sided adhesive, and may be formed of a material such as acryl and silicone.

Accordingly, an insulating layer of a capacitive touch screen panel described herein may be fabricated by inkjet printing, thus contributing to simplification of the process, a decrease in waste of materials, and a reduction in the manufacturing cost. Furthermore, a plasma etching process may be performed before an insulating layer is printed, thereby reducing the contact angle. As a result, a conductive layer thicker than a conventional conductive layer may be deposited on the insulating layer having a reduced contact angle, such that the conductive layer has a lower resistance and is more stabilized.

Program instructions to perform a method described herein, or one or more operations thereof, may be recorded, stored, or fixed in one or more computer-readable storage media. The program instructions may be implemented by a computer. For example, the computer may cause a processor to execute the program instructions. The media may include, alone or in combination with the program instructions, data files, data structures, and the like. Examples of computer-readable storage media include magnetic media, such as hard disks, floppy disks, and magnetic tape; optical media such as CD ROM disks and DVDs; magneto-optical media, such as optical disks; and hardware devices that are specially configured to store and perform program instructions, such as read-only memory (ROM), random access memory (RAM), flash memory, and the like. Examples of program instructions include machine code, such as produced by a compiler, and files containing higher level code that may be executed by the computer using an interpreter. The program instructions, that is, software, may be distributed over network coupled computer systems so that the software is stored and executed in a distributed fashion. For example, the software and data may be stored by one or more computer readable storage mediums. Also, functional programs, codes, and code segments for accomplishing the example embodiments disclosed herein can be easily construed by programmers skilled in the art to which the embodiments pertain based on and using the flow diagrams and block diagrams of the figures and their corresponding descriptions as provided herein. Also, the described unit to perform an operation or a method may be hardware, software, or some combination of hardware and software. For example, the unit may be a software package running on a computer or the computer on which that software is running.

As a non-exhaustive illustration only, a terminal/device/unit described herein may refer to mobile devices such as a cellular phone, a personal digital assistant (PDA), a digital camera, a portable game console, and an MP3 player, a portable/personal multimedia player (PMP), a handheld e-book, a portable laptop PC, a global positioning system (GPS) navigation, a tablet, a sensor, and devices such as a desktop PC, a high definition television (HDTV), an optical disc player, a setup box, a home appliance, and the like that are capable of wireless communication or network communication consistent with that which is disclosed herein.

A computing system or a computer may include a microprocessor that is electrically connected with a bus, a user interface, and a memory controller. It may further include a flash memory device. The flash memory device may store N-bit data via the memory controller. The N-bit data is processed or will be processed by the microprocessor and N may be 1 or an integer greater than 1. Where the computing system or computer is a mobile apparatus, a battery may be additionally provided to supply operation voltage of the computing system or computer. It will be apparent to those of ordinary skill in the art that the computing system or computer may further include an application chipset, a camera image processor (CIS), a mobile Dynamic Random Access Memory (DRAM), and the like. The memory controller and the flash memory device may constitute a solid state drive/disk (SSD) that uses a non-volatile memory to store data.

A number of examples have been described above. Nevertheless, it will be understood that various modifications may be made. For example, suitable results may be achieved if the described techniques are performed in a different order and/or if components in a described system, architecture, device, or circuit are combined in a different manner and/or replaced or supplemented by other components or their equivalents. Accordingly, other implementations are within the scope of the following claims.

## Claims

1. A method for fabricating a transparent circuit board for a touch screen, the method comprising:
forming a transparent substrate on which a conductive bridge layer is deposited;
depositing a liquid insulating layer on the transparent substrate and on the bridge layer; and
depositing a sensor layer on the transparent substrate and the insulating layer, the sensor layer comprising first and second conductive patterns that cross each other.

2. The method of claim 1, wherein the liquid insulating layer is deposited by an inkjet printing process.

3. The method of claim 1 or 2. wherein the forming of the transparent substrate comprises:
depositing a conductive layer on a surface of the transparent substrate; and
plasma-etching the surface of the transparent substrate on which the conductive layer is deposited to form the conductive bridge layer.

4. The method of one of claims 1 to 3, further comprising washing the plasma-etched surface of the transparent substrate with an alkaline solution.

5. The method of claim 4, wherein the alkaline solution comprises at least one of tetramethylammonium hydroxide (TMAH) and NaHCO₃.

6. The method of one of claims 1 to 5, further comprising curing the liquid insulating layer by heating the liquid insulating layer.

7. The method of one of claims 1 to 6, further comprising:
depositing a light blocking layer on edges of the transparent substrate; and
depositing an electrode layer on the light blocking layer;
wherein the electrode layer is electrically connected to the sensor layer.

8. The method of one of claims 1 to 7, further comprising depositing an insulating protective layer onto the sensor layer such that the insulating protective layer is interposed between the first and second conductive patterns.

9. A transparent circuit board for a touch screen, the transparent circuit board comprising:
a transparent substrate comprising a conductive bridge layer which has undergone plasma etching;
an insulating layer deposited on the transparent substrate and on the conductive bridge layer; and
a sensor layer comprising first and second conductive patterns that cross each deposited on the transparent substrate and the insulating layer.

10. The transparent circuit board of claim 9, wherein the insulating layer is deposited by an inkjet printing process.

11. The transparent circuit board of claim 9 or 10, wherein an angle of inclination of an edge of the insulating layer ranges from 30° to 60°.

12. The transparent circuit board of one of claims 9 to 11, further comprising:
a light blocking layer deposited on edges of the transparent substrate; and
an electrode layer deposited on the insulating light blocking layer and electrically connected to the sensor layer.

13. A touch screen comprising:
the transparent circuit board of one of claims 9 to 12; and
a display unit configured to display an image.
